Europäisches Patentamt

European Patent Office

Office européen des brevets

(11) Publication number: **0 222 338 B1**

## EUROPEAN PATENT SPECIFICATION

(45) Date of publication of patent specification: **15.04.92**  (51) Int. Cl.⁵: **H01L 31/02**, H01L 27/14

(21) Application number: **86115449.0**

(22) Date of filing: **07.11.86**

(54) Semiconductor photo-sensing device.

(30) Priority: **12.11.85 JP 253211/85**

(43) Date of publication of application:
**20.05.87 Bulletin  87/21**

(45) Publication of the grant of the patent:
**15.04.92 Bulletin  92/16**

(84) Designated Contracting States:
**DE FR GB**

(56) References cited:
**EP-A- 0 108 480**
**EP-A- 0 148 687**

**PATENT ABSTRACTS OF JAPAN, vol. 10, no.
16 (E-375)[2073], 22nd January 1986 & JP-
A-60 177 685 (SUMITOMO DENKI KOGYO
K.K.) 11-09-1985**

**PATENT ABSTRACTS OF JAPAN, vol. 6, no.
247 (E-146)[1125], 7th December 1982 & JP-
A-57 145 368 (HITACHI SEISAKUSHO K.K.)
08-09-1982**

(73) Proprietor: **KABUSHIKI KAISHA TOSHIBA
72, Horikawa-cho Saiwai-ku
Kawasaki-shi Kanagawa-ken 210(JP)**

(72) Inventor: **Katayama, Takao Patent Division
K.K. Toshiba 1-1 Shibaura 1-chome
Minato-ku Tokyo 105(JP)**
Inventor: **Motodate, Junya Patent Division
K.K. Toshiba 1-1 Shibaura 1-chome
Minato-ku Tokyo 105(JP)**

(74) Representative: **Lehn, Werner, Dipl.-Ing. et al
Hoffmann, Eitle & Partner Patentanwälte Ar-
abellastrasse 4
W-8000 München 81(DE)**

## Description

The present invention relates to a photo-sensing device, and more particularly to a semiconductor photo-sensing device suitably adapted to photoelectric switches, optical fiber data links, high speed optical communication, etc.

Previously known semiconductor photo-sensing devices are provided with a photosensor for photoelectric conversion and an amplifier circuit for amplifying the output from the photosensor. The photosensor is constructed by a PN-junction diode, for example while the amplifier circuit is constructed by bipolar transistors, diodes, resistors, etc., for example.

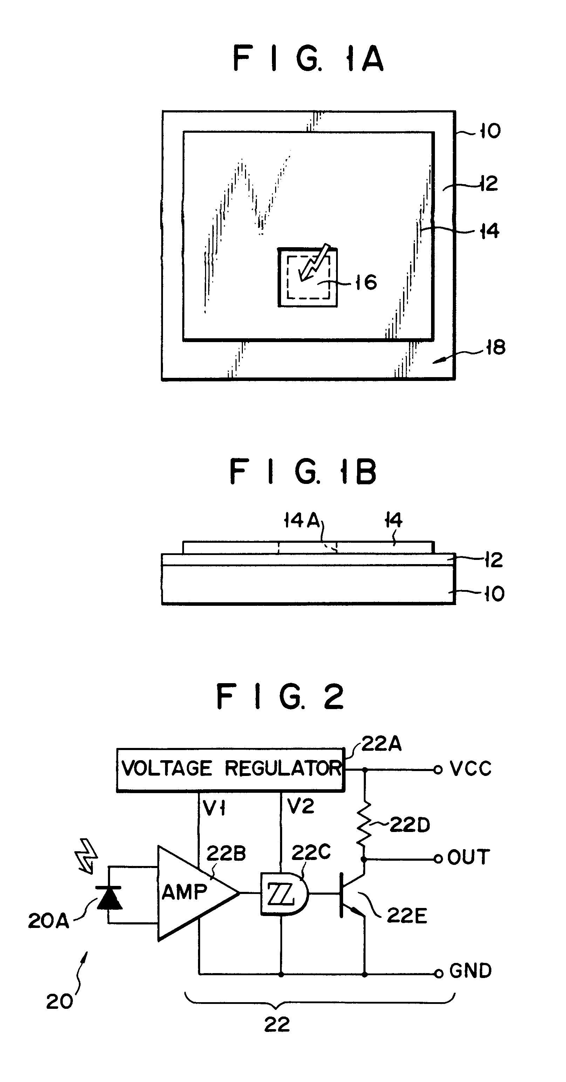

These circuit components or elements are integrated in a single semiconductor chip in the prior art monolithic semiconductor photo-sensing device as shown in Figs. 1A and 1B. These circuit elements are formed in the semiconductor substrate 10 through diffusion techniques, and are interconnected by wiring layers. The surface of the semiconductor substrate 10 is entirely covered with an insulating film 12 which is capable of transmitting a light having a desired wavelength, and the wiring layers are disposed in the insulating film 12 in contact with the circuit elements.

In the semiconductor photo-sensing device mentioned above, the PN-junction diode employs a photocurrent which will flow when a light is emitted to the vicinity of the PN-junction thereof. On the other hand, if the light were irradiated to a transistor in the amplifier circuit, a photocurrent would flow through the PN-junctions between the base and collector and between the emitter and base. The photocurrent flowing in the amplifier circuit gives rise to noise or malfunction when the amplifier circuit is in operation. To obviate this disadvantage, the prior art photo-sensing device is provided with a light-shading layer 14, e.g., aluminum, as shown in Figs. 1A and 1B. Layer 14 is formed on substantially the whole surface of the insulating film 12 except the portions corresponding to a light receiving region 16 of the photosensor and a bonding region 18, thereby entirely masking the amplifier circuit.

A semiconductor device of this kind is also known from JP-A-60-177 685.

The prior art semiconductor photo-sensing device described above, however, could not provide a higher production yield and sufficient reliability in the operation thereof. This is greatly attributable to the facts that some pinholes may be produced in the insulating film 12; parasitic capacitances may be generated between the light-shading layer 14 and the wiring layers; and moisture may be contained in the insulating film 12. These causes will be explained below in more detail.

First, the insulating film 12 may contain pinholes on the circuit elements or wiring layers. In this case, the portions associated with the pinholes remain exposed. Therefore, if aluminum is vacuum-deposited on the insulating layer 12 for the provision of the light-shading layer 14, the aluminum will be also deposited on the exposed portions of the circuit elements or wiring layers through the pinholes. Thus, these exposed portions will be disadvantageously communicated or short-circuited with each other by the light-shading layer 14.

Secondly, both the light-shading layer 14 and the wiring layers are electrically conductive, and are adjacent to each other through the insulating layer 12. Therefore, each of the wiring layers is capacitively coupled with the light-shading layer to provide the parasitic capacitance therebetween. This parasitic capacitance will lead to the noise at a noticeable level in the operation of the amplifier circuit.

Finally, the moisture contained in the insulating layer 12 will be vaporized due to the heat applied during the heat treatment after the aluminum deposition, e.g., molding process, and will be stored as bubbles within the insulating film 12 covered with the light-shading layer 14. Therefore, a relatively large force will be applied to portions of the wiring layers and light-shading layer 14, thus deforming them. Accordingly, some disconnections may occur in the wiring layers and/or poor insulation may result between the wiring layers and the light-shading layer 14. This inconvenience is more liable to occur than the inconveniences resulting from the pinholes and parasitic capacitances and so it is most critical. Incidentally, in the case where the insulating layer 12 is configured in a multi-layer structure, in which one layer is made of a highly adsorbent material such as polyimide, it has been confirmed by the inventor of the present invention that the inconvenience due to the presence of the bubbles occurs in many cases. It has been also confirmed that the disconnections and poor insulation are liable to occur below the center portion of the light-shading layer 14.

It can be easily understood by those skilled in the art that the inconveniences mentioned above will be involved in not only the monolithic semiconductor photo-sensing device but in the hybrid type of semiconductor photo-sensing device in which a photosensor and an amplifier circuit formed in individual semiconductor chips are sealed in a single package.

An object of the present invention is to provide a semiconductor photo-sensing device which is capable of providing a higher production yield and sufficient operation reliability.

To attain this object, in accordance with the present invention, there is provided a semiconductor photo-sensing device comprising a substrate means, a photo-sensor means for photoelectric conversion, a plurality of processing means formed in the substrate means for cooperatively processing an output signal of the photosensor means and containing at least one PN-junction, an insulative light-transmission film formed on the substrate means and a light-shading layer formed on the insulative film for masking the restricted areas corresponding to the respective processing means and a miniumum of their neighboring areas.

In the semiconductor photo-sensing device according to the present invention, the light-shading layer is not formed on substantially the whole surface of the insulating film, but on a comparatively small area thereof, enough to mask only the regions where the processing sections are formed and their neighboring areas. Therefore, even if the insulating film is highly adsorbent, the moisture contained in the insulating film is not stored as bubbles below the center portion of the light-shading layer during the heat treatment, but can be sufficiently emitted, externally. The occurrence of the inconvenience resulting from the pinholes and parasitic capacitances can be also minimized, since the area of the light-shading layer is minimized in an allowable range.

The above and other objects, features and advantages of the present invention will be more clearly understood from the following detailed description taken in conjunction with the accompanying drawings, in which like reference numerals refer to like parts in the various views.

Figs. 1A and 1B are a plan view and sectional view of the prior art semiconductor photo-sensing device, respectively;

Fig. 2 is a circuit diagram of a semiconductor photo-sensing device according to a first embodiment of the present invention;

Fig. 3 is a plan view of the semiconductor chip in which the circuit of Fig. 2 is formed;

Fig. 4 is a sectional view taken along line I-I of Fig. 3;

Fig. 5 is a graph showing the relation between the wavelength of the light incident on the semiconductor substrate shown in Figs. 3 and 4 and the absorption coefficient $\alpha_o$

Fig. 6 is a plan view of a semiconductor photo-sensing device according to a second embodiment of the present invention, analogous to the first embodiment, in which the light-shading layers shown in Fig. 3 are connected with each other;

Fig. 7 is a plan view of a semiconductor photo-sensing device according to a third embodiment of the present invention, analogous to the second embodiment, in which the photosensor shown in Fig. 2 is formed in an individual semiconductor chip; and

Fig. 8 is a plan view of a semiconductor photo-sensing device according to a fourth embodiment of the present invention, analogous to the second embodiment, in which the photosensor and a part of the amplifier circuit shown in Fig. 2 are formed in an individual semiconductor chip.

Explanation will be given for the first embodiment with reference to Figs. 2 to 5. As seen from Fig. 2 showing the circuit arrangement of the semiconductor photo-sensing device according to this embodiment, this photo-sensing device includes a photo-sensor 20 for photo-electric conversion and an amplifier circuit 22 for amplifying the output signal from the photosensor 20. The photosensor 20 is constructed by a diode 20A which can efficiently photoelectrically convert the light having a desired wavelength, e.g., infrared light having a wavelength of 940 nm. The amplifier circuit 22 is constructed by a voltage regulator 22A, amplifier 22B, Schmitt circuit 22C, load resistor 22D and output transistor 22E, for example.

The semiconductor photo-sensing device according to this embodiment operates as follows. A power source voltage is applied between terminals Vcc and GND and stabilized by the voltage regulator 22A. The diode 20A generates an electric signal in accordance with the intensity of an incident light. This electric signal is amplified by the amplifier 22B, and is supplied as a voltage signal to the Schmitt circuit 22C. The Schmitt circuit 22C compares the level of the supplied voltage signal with a reference voltage level and controls the conduction state of the output transistor 22E in accordance with the level difference. The voltage at an output terminal OUT is set to a low level when the transistor 22E is turned on, and set to a high level when the transistor 22E is turned off. This means that a digital signal is produced from the output terminal OUT.

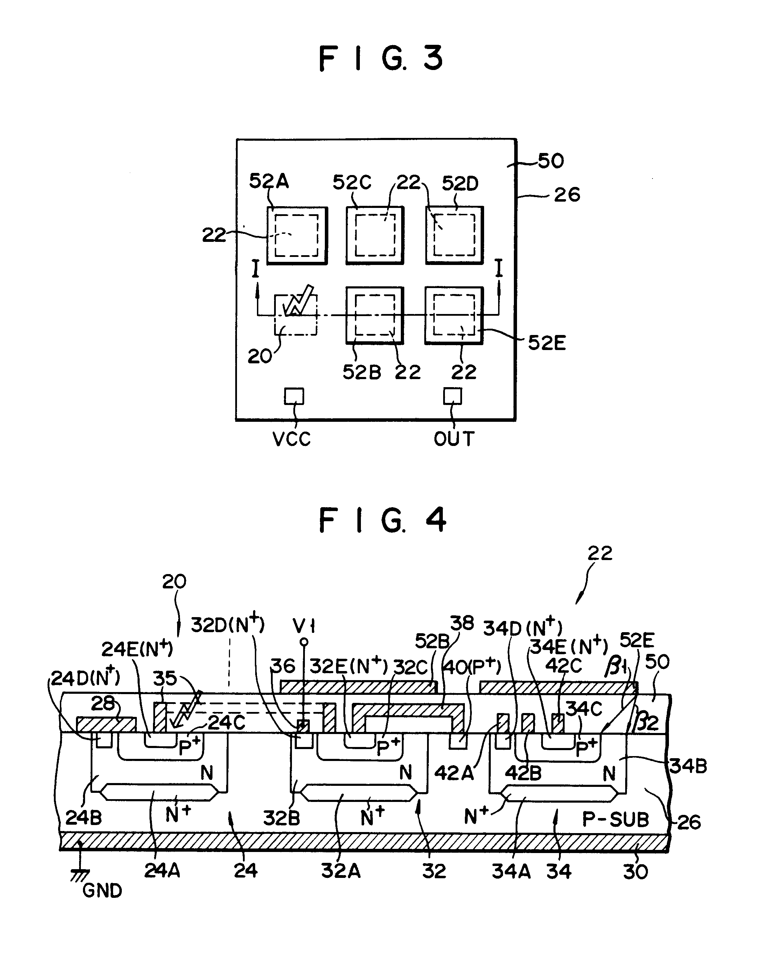

Referring now to Figs. 3 and 4, the structure of the semiconductor photo-sensing device according to this embodiment will be explained. The photosensor 20 and amplifier circuit 22, that is, the diode 20A, voltage regulator 22A, amplifier 22B, Schmitt circuit 22C, load resistor 22D and output transistor 22E are arranged in a single semiconductor chip as shown in Fig. 3.

More specifically, the photosensor 20 has a vertical NPN transistor 24 as shown in Fig. 4 to provide the diode 20A. The transistor 24 has an $N^+$-type region 24A buried within a P-type silicon substrate 26 and an N-type region 24B which is formed, in contact with the region 24A, in the surface area of the substrate 26. The transistor 24 has also a $P^+$-type region 24C and $N^+$-type region 24D which are formed in the surface area of the region 24B, and an $N^+$-type region 24E which is formed in the surface area of the region 24C. A conductive layer, e.g., aluminum Aℓ layer 28 is formed on the regions 24B, 24C, 24D and substrate 26. Thus, the Aℓ layer 28 serves as an anode electrode and a wiring layer. The regions 24B and 24C are short-circuited through the region 24D and Aℓ layer 28. An Aℓ layer 30 is formed on the bottom surface of the substrate 26, and serves as a terminal GND. The PN-junction between the regions 24C and 24E and its neighborhood are used as a light-receiving portion of the diode 20A.

On the other hand, the amplifier circuit 22 has vertical NPN transistors 32 and 34 as shown in Fig. 4 to provide the amplifier 22B and output transistor 22E. The transistor 32 is manufactured in the same manner as the transistor 24, and has an $N^+$-type region 32A, N-type region 32B, $P^+$-type region 32C, $N^+$-type region 32D and $N^+$-type region 32E. An Aℓ layer 35 is formed on the region 24E as a cathode electrode of the diode 24 and formed on the region 32C as a base electrode of the transistor 32; these regions 24C and 32 are connected with each other through the Aℓ layer 35. An Aℓ layer 36 is formed on the region 32D as a collector electrode of the transistor 32, and receives a regulated power voltage V1 from voltage regulator 22A. An Aℓ layer 38 is formed on the region 32E as an emitter electrode of the transistor 32, and also contacts with a $P^+$-type region formed in the surface area of the substrate 26. Further, the transistor 34, like the transistor 32, has $N^+$-type regions 34A, 34D and 34E, an N-type region 34B and a $P^+$-type region 34C. Aℓ layers 42A, 42B and 42C are formed in contact with the regions 34D, 34C and 34E, respectively.

Moreover, as shown in Fig. 4 an insulating film 50 is formed on the substrate 26 and transistors 24, 32 and 34. This insulating film 50 serves to electrically insulate the Aℓ layers from one another and also to permit the light to be transmitted. Further, as shown in Figs. 3 and 4, light-shading layers 52A to 52E of e.g. Aℓ are formed on the insulating film 50, and mask the areas where the voltage regulator 22A, amplifier 22B, Schmitt circuit 22c, load resistor 22D and output transistor 22E are formed, and their neighboring areas.

The areas of the light-shading layers 52A to 52E are defined so that the amount of light incident on the PN-junctions and their neighboring area can be made as little as possible within the range of not invalidating the circuit operation of the photosensing device. This will be explained in more detail hereinbelow.

When a semiconductor crystal receives a light, the light can penetrate in the crystal by the depth Lα (referred to as an absorption length). This absorption length Lα can be expressed as

$$L\alpha = 1/\alpha_o \qquad (1)$$

where $\alpha$ is an absorption coefficient of the semiconductor crystal. If the PN-junction of the photodiode in the photosensor is placed at Lα, the photosensor can perform the photo-electric conversion with a maximum efficiency for the incident light.

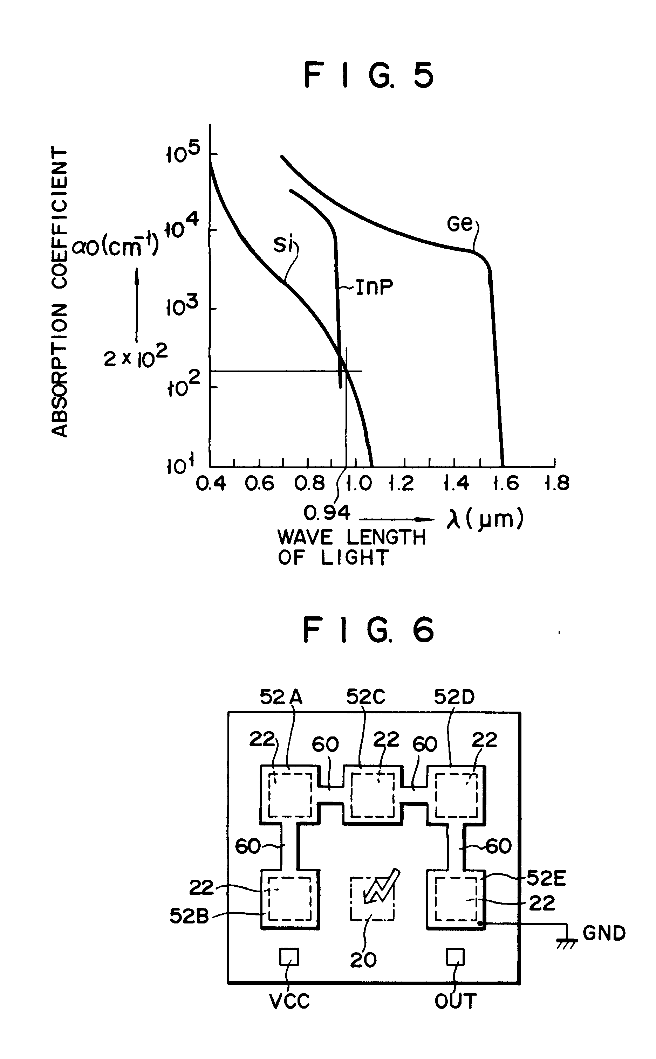

Therefore, in order to prevent the light of a specific wavelength from arriving at a certain PN-junction, it is necessary to perform light-shading for the area, at least, extending from the PN-junction to a position of Lα. Now, it is assumed that the infrared light having a wavelength of 940 nm (0.94 μm) is emitted to the silicon substrate 26, as shown in Figs. 3 and 4, from the infrared diode serving as a light source. In this case, the absorption coefficient $\alpha_o$ is approximately $2 \times 10^2$ cm$^{-1}$ as seen from Fig. 5 which shows a relation between the wavelength (μm) and the absorption coefficient (cm$^{-1}$) for the respective semiconductor crystals of silicon (Si), indium phosphide (InP) and germanium (Ge). And the absorption length is approximately $5 \times 10^{-3}$ cm, i.e., 50 μm, from the equation (1). Assuming that in the sectional section of Fig. 4, the distance from the edge of the light-shading layer 52E to the PN-junction between the regions 34C and 34B is $\beta_1$, $\beta_1$ must be set to a value of 5 μm or more for the aforementioned reason. This will provide a substantially satisfactory light-shading effect for the transistor 34.

Nevertheless, since the absorption length Lα as defined above means a distance when the intensity of the incident light is reduced to 1/e (e:exponential 2.718 ...) thereof, approximately 37 % of the incident light will reach the PN-junction. Therefore, in order to sufficiently eliminate the noise due to the incident light, the thickness of the depletion layer along a PN-junction, the width of the diffused region must be considered. When the light is emitted to the PN-junction between the regions 34C and 34B, some carriers will be produced. The carriers will be amplified because of the amplifying operation of the transistor 34 to create noticeable noise. Therefore, assuming that the distance from the edge of the light-shading layer 52E to the outermost PN-junction of the transistor 34 is $\beta_2$, $\beta_2$ must also be set to a value of 50 μm or more. Thus, in this embodiment, the light-shading layer 52E is made apart from the PN-junction between the region 34B and the substrate 26 by 50 μm or more. The other light-shading layers 52A to 52D are also made apart from the outermost PN-junctions of the associated semiconductor elements by 5 μm or more.

In accordance with this embodiment, since the region for which the light-shading is to be performed is minimized, the area of the light-shading layers can be sufficiently reduced as compared with the prior art semiconductor photo-sensing device. Thus, the possibility of producing short-circuiting among the wiring layers due to the presence of pinholes can be minimized. The noise resulting from the parasitic capacitances between the light-shading layers and the wiring layers can also be minimized. Further, the disconnections in the wiring layers and poor insulation between the wiring layers and light shading-layers, which are produced due to the moisture contained in the insulating layer, can be efficiently reduced. This is because the reduction of the area of the light-shading layers assures that the moisture, when vaporized, can easily emit externally so that it is not stored as bubbles between the light-shading layers and the insulating film. Accordingly, the reliability of the semiconductor photo-sensing device according to this embodiment can be greatly improved.

Incidentally, in this embodiment, a silicon substrate 26 was employed but the semiconductor substrate of other materials can also be employed. When the wavelength of incident light is varied, it is only necessary to change the thickness of the insulating layer 50 and the pattern, size, etc. of each of the light-shading layers 52A to 52E. Further, although the photo-diode 20A was constructed by the NPN transistor 24 with its base and collector short-circuited, it can be constructed by an ordinary PN-junction photodiode.

Fig. 6 shows a planar structure of the semiconductor photo-sensing device according to a second embodiment of the present invention. This device is the same as the device according to the first embodiment except that the light-shading layers 52A to 52E are connected with one another through a connection layer 60 of the same material, i.e., Aℓ, as the light-shading layers and are grounded. The circuit structure of the device according to this embodiment is equivalent to that of the device according to the first embodiment as shown in Fig. 2 although the arrangement of the photosensor 20 and amplifier circuit 22 in this embodiment is different from the first embodiment as shown in Fig. 3. The device according to this embodiment can provide a more improved electromagnetic shielding effect.

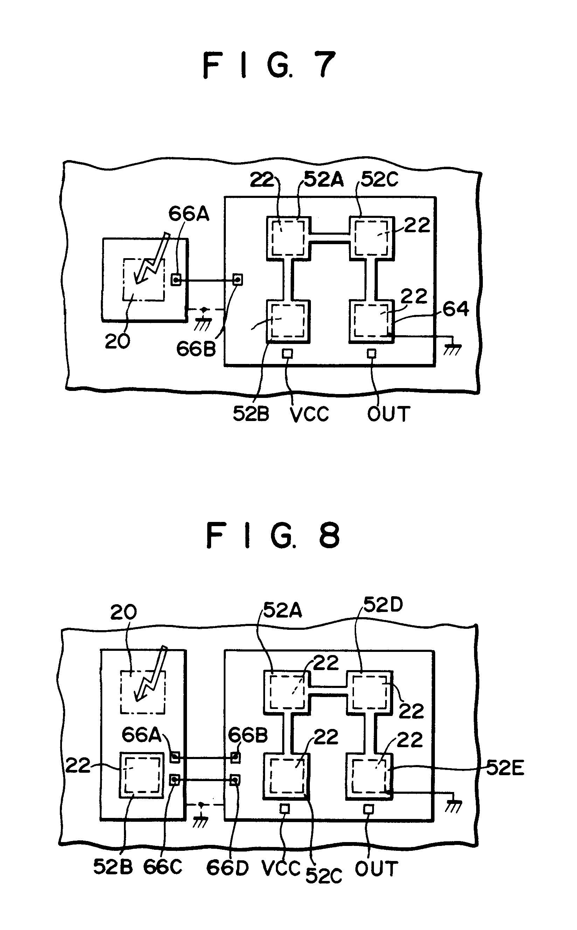

Fig. 7 shows a planar structure of the semiconductor photo-sensing device according to a third embodiment of the present invention. This device is the same as the device according to the second embodiment except that the photosensor 20 and amplifier circuit 22 are formed in individual first and second semiconductor chips, respectively, which are connected with each other through their associated bonding pads 66A and 66B and are grounded. Although the circuit structure of the amplifier circuit 22 in this embodiment is equivalent to that as shown in Fig. 2, both the load resistor 22D and output transistor 22E, for example, are masked by a common light-shading layer 64. The device according to this embodiment can provide the same effect as the second embodiment.

Fig. 8 shows a planar structure of the semiconductor photo-sensing device according to a fourth embodiment of the present invention. This device is the same as the device according to the second embodiment except that the photosensor 20 and a part of the amplifier circuit 22, e.g., the amplifier 22B, are formed in a first individual semiconductor chip while the remaining part of the amplifier circuit 22 is formed in a second individual semiconductor chip; the first and second semiconductor chips are connected with each other through their associated bonding pads 66A, 66B, 66C and 66D and are grounded. The device according to this embodiment can provide the same effect as the second embodiment.

**Claims**

1.  A semiconductor photo-sensing device comprising:
    substrate means (26);
    photosensor means (20) for photo-electric conversion;
    processing means (22), formed in said substrate means (26) and containing at least one PN-junction, for processing an output signal of said photosensor means (20);
    an insulative light-transmission film (50) formed on said substrate means (26); and
    light-shading means (52A-52E) formed on said light-transmission film (50)
    characterized in that
    said light-shading means (52A-52E) masks only an area corresponding to the processing means (22) and a minimum of its neighboring area, said minimum determined such that operation of said processing means (22) is not invalidated by incident light.

2.  A semiconductor photo-sensing device according to claim 1, characterized in that said processing means (22) is formed of a plurality of processing sections (22A-22E) for cooperatively processing an output signal of said photosensor means (20), each of said processing sections (22A-22E) containing at least one PN-junction.

3.  A semiconductor photo-sensing device according to claim 2, characterized in that said light-shading means includes a plurality of light-shading layers (52A-52E) for masking the restricted areas corresponding to the respective processing sections (22A-22E) and their neighboring areas.

4. A semiconductor photo-sensing device according to claim 3, characterized in that each of said light-shading layers (52A-52E) is conductive and is connected to ground.

5. A semiconductor photo-sensing device according to claim 4, characterized in that said light-shading means further includes at least one conductive line (60) for connecting said light-shading layers (52A-52E) in series.

6. A semiconductor photo-sensing device according to claim 5, characterized in that said light-shading layers (52A-52E) and conductive line (60) are formed of aluminium.

7. A semiconductor photo-sensing device according to claim 1, characterized in that said substrate means is formed of a single semiconductor substrate (26), said photosensor means (20) and processing means (22) are formed in said semiconductor substrate (26).

8. A semiconductor photo-sensing device according to claim 1, characterized in that said substrate means is formed of first and second semiconductor substrates, said photosensor means (20) is formed in said first semiconductor substrate, and said processing means (22) is formed in said second semiconductor substrate.

9. A semiconductor photo-sensing device according to claim 1, characterized in that said substrate means is formed of first and second semiconductor substrates, said photosensor means (20) and part of said processing means (22) are formed in said first semiconductor substrate, and the remaining part of said processing means (22) is formed in said second semiconductor substrate.

10. A semiconductor photo-sensing device according to claim 1, characterized in that said processing means is formed as an amplifier circuit (22).

11. A semiconductor photo-sensing device according to claim 2, characterized in that at least one of said processing sections (22A-22E) includes a bipolar transistor.

12. A semiconductor photo-sensing device according to claim 1, characterized in that said light-shading means (52A-52E) is laid over said processing means (22) with a peripheral edge being apart from the outermost PN-junction of said processing means (22) by a predetermined distance.

13. A semiconductor photo-sensing device according to claim 12, characterized in that said substrate means (26) is formed of silicon, and said predetermined distance is at least 50 $\mu$m.

**Revendications**

1. Dispositif de photo-détection à semiconducteur comprenant :
   un moyen de substrat (26) :
   un moyen de photo-détecteur (20) pour une conversion photo-électrique ;
   un moyen de traitement (22), formé dans ledit moyen de substrat (26) et contenant au moins une jonction PN, pour traiter un signal de sortie dudit moyen de photo-détecteur (20) ;
   un film de transmission de lumière isolant (50) formé sur ledit moyen de substrat (26) ; et
   un moyen d'écran à la lumière (52A-52E) formé sur ledit film de transmission de lumière (50),
   caractérisé en ce que :
   ledit moyen d'écran à la lumière (52A-52E) masque seulement une zone correspondant au moyen de traitement (22) et une partie minimum de sa zone avoisinante, ladite partie minimum étant déterminée de telle sorte que le fonctionnement dudit moyen de traitement (22) ne soit pas invalidé par la lumière incidente.

2. Dispositif de photo-détection à semiconducteur selon la revendication 1, caractérisé en ce que ledit moyen de traitement (22) est formé d'une pluralité de sections de traitement (22A-22E) pour traiter en coopération un signal de sortie dudit moyen de photo-détecteur (20), chacune desdites sections de traitement (22A-22E) contenant au moins une jonction PN.

3. Dispositif de photo-détection à semiconducteur selon la revendication 2, caractérisé en ce que ledit moyen d'écran à la lumière inclut une pluralité de couches d'écran à la lumière (52A-52E) pour masquer la zone limitée correspondant aux sections de traitement respectives (22A-22E) et à leurs zones avoisinantes.

4. Dispositif de photo-détection à semiconducteur selon la revendication 3, caractérisé en ce que chacune desdites couches d'écran à la lumière (52A-52E) est conductrice et est reliée à la masse.

5. Dispositif de photo-détection à semiconducteur selon la revendication 4, caractérisé en ce que ledit moyen d'écran à la lumière inclut en outre au moins une ligne conductrice (60) pour connecter en série lesdites couches d'écran à la lumière (52A-52E).

6. Dispositif de photo-détection à semiconducteur selon la revendication 5, caractérisé en ce que lesdites couches d'écran à la lumière (52A-52E) et ladite ligne conductrice (60) sont réalisées en aluminium.

7. Dispositif de photo-détection à semiconducteur selon la revendication 1, caractérisé en ce que ledit moyen de substrat est constitué par un substrat semiconducteur unique (26) et ledit moyen de photo-détecteur (20) et ledit moyen de traitement (22) sont réalisés dans ledit substrat semiconducteur (26).

8. Dispositif de photo-détection à semiconducteur selon la revendication 1, caractérisé en ce que ledit moyen de substrat est constitué par des premier et second substrats semiconducteurs, ledit moyen de photo-détecteur (20) est réalisé dans ledit premier substrat semiconducteur et ledit moyen de traitement (22) est réalisé dans ledit second substrat semiconducteur.

9. Dispositif de photo-détection à semiconducteur selon la revendication 1, caractérisé en ce que ledit moyen de substrat est constitué par des premier et second substrats semiconducteurs, ledit moyen de photo-détecteur (20) et une partie dudit moyen de traitement (22) sont réalisés dans ledit premier substrat semiconducteur et ladite partie restante dudit moyen de traitement (22) est réalisée dans ledit second substrat semiconducteur.

10. Dispositif de photo-détection à semiconducteur selon la revendication 1, caractérisé en ce que ledit moyen de traitement est constitué par un circuit amplificateur (22).

11. Dispositif de photo-détection à semiconducteur selon la revendication 2, caractérisé en ce qu'au moins une desdites sections de traitement (22A-22E) inclut un transistor bipolaire.

12. Dispositif de photo-détection à semiconducteur selon la revendication 1, caractérisé en ce que ledit moyen d'écran à la lumière (52A-52E) s'étend au-dessus dudit moyen de traitement (22), un bord périphérique étant espacé d'une distance prédéterminée de la jonction PN la plus externe dudit moyen de traitement (22).

13. Dispositif de photo-détection à semiconducteur selon la revendication 12, caractérisé en ce que ledit moyen de substrat (26) est constitué par du silicium et ladite distance est égale à au moins 50 $\mu$m.

**Patentansprüche**

1. Lichtempfindliche Halbleitervorrichtung, die folgende Mittel aufweist:
   - Substratmittel (26);
   - Lichtsensormittel (20) für die lichtelektrische Umwandlung;
   - Verarbeitungsmittel (22) zur Verarbeitung eines Ausgangssignals der Lichtsensormittel (20), wobei erstere in den Substratmitteln (26) ausgebildet sind und mindestens einen einzelnen PN-Übergang aufweisen;
   - einen lichtdurchlässigen Isolierfilm (50) auf den Substratmitteln (26); und
   - Lichtabschirmmittel (52A-52E) auf dem lichtdurchlässigen Film,
   dadurch **gekennzeichnet,** daß die Lichtabschirmmittel (52A-52E) nur einen Bereich maskieren, der den Verarbeitungsmitteln (22) und einem Minimum ihrer benachbarten Bereiche entspricht, wobei das Minimum so festgesetzt ist, daß der Betrieb der Verarbeitungsmittel (22) nicht durch einfallendes Licht unwirksam gemacht wird.

2. Lichtempfindliche Halbleitervorrichtung nach Anspruch 1,
   dadurch **gekennzeichnet,** daß die Verarbeitungsmittel aus einer Vielzahl von Verarbeitungsabschnitten (22A-22E9 zur kooperativen Verarbeitung eines Ausgangssignals der Lichtsensormittel (20) bestehen, wobei jeder der Verarbeitungsabschnitte (22A-22E) mindestens einen einzelnen PN-Übergang aufweist.

3. Lichtempfindliche Halbleitervorrichtung nach Anspruch 2,
   dadurch **gekennzeichnet,** daß die Lichtabschirmmittel eine Vielzahl von Lichtabschirmschichten (52A-52E) zum Maskieren der begrenzten Bereiche entsprechend den jeweiligen Verarbeitungsabschnitten (22A-22E) und ihrer benachbarten Bereiche aufweisen.

4. Lichtempfindliche Halbleitervorrichtung nach Anspruch 3,
   dadurch **gekennzeichnet,** daß jede der lichtabschirmenden Schichten (52A-52E) leitend und mit Erde verbunden ist.

5. Lichtempfindliche Halbleitervorrichtung nach Anspruch 4,
dadurch **gekennzeichnet,** daß die lichtabschirmenden Mittel weiter mindestens eine leitende Leitung (60) zum Anschließen der lichtabschirmenden Schichten (52A-52E) in Reihenschaltung aufweisen.

6. Lichtempfindliche Halbleitervorrichtung nach Anspruch 5,
dadurch **gekennzeichnet,** daß die lichtabschirmenden Schichten (52A-52E) sowie die leitende Leitung (60) aus Aluminium bestehen.

7. Lichtempfindliche Halbleitervorrichtung nach Anspruch 1,
dadurch **gekennzeichnet,** daß die Substratmittel aus einem einzelnen Halbleitersubstrat (26) bestehen, wobei die lichtempfindlichen Mittel (20) und die Verarbeitungsmittel (22) im Halbleitersubstrat (26) ausgebildet sind.

8. Lichtempfindliche Halbleitervorrichtung nach Anspruch 1,
dadurch **gekennzeichnet,** daß die Halbleitermittel aus einem ersten und einem zweiten Halbleitersubstrat bestehen, wobei die lichtempfindlichen Mittel (20) im ersten Halbleitersubstrat und die Verarbeitungsmittel (22) im zweiten Halbleitersubstrat ausgebildet sind.

9. Lichtempfindliche Halbleitervorrichtung nach Anspruch 1,
dadurch **gekennzeichnet,** daß die Substratmittel aus einem ersten und einem zweiten Halbleitersubstrat bestehen, wobei die lichtempfindlichen Mittel (20) sowie ein Teil der Verarbeitungsmittel (22) im ersten Halbleitersubstrat, und der restliche Teil der Verarbeitungsmittel (22) im zweiten Halbleitersubstrat ausgebildet ist.

10. Lichtempfindliche Halbleitervorrichtung nach Anspruch 1,
dadurch **gekennzeichnet,** daß die Verarbeitungsmittel als Verstärkerschaltung (22) ausgebildet sind.

11. Lichtempfindliche Halbleitervorrichtung nach Anspruch 2,
dadurch **gekennzeichnet,** daß mindestens einer der Verarbeitungsabschnitte (22A-22E) einen Bipolartransistor aufweist.

12. Lichtempfindliche Halbleitervorrichtung nach Anspruch 1,
dadurch **gekennzeichnet,** daß die lichtabschirmenden Mittel (52A-52E) über die Verarbeitungsmittel (22) geschichtet sind, wobei eine Umfangskante zum äußersten PN-Übergang der Verarbeitungsmittel (22) einen vorbestimmten Abstand einhält.

13. Lichtempfindliche Halbleitervorrichtung nach Anspruch 12,
dadurch **gekennzeichnet,** daß die Substratmittel (26) aus Silicium bestehen und der vorbestimmte Abstand mindestens 50 $\mu$m beträgt.

# F I G. 1A

10

12

14

16

18

# F I G. 1B

14A    14

12

10

# F I G. 2

VOLTAGE REGULATOR    22A

○ VCC

V1    V2

22D

22B    22C

○ OUT

AMP    Z

20A    22E

20    ○ GND

22

# F I G. 3

# F I G. 4

# F I G. 5

# F I G. 6

# F I G. 7

# F I G. 8